# EUROPEAN PATENT APPLICATION

(11) **EP 2 672 533 A2**
(43) Date of publication of application: **11.12.2013**
(21) Application number: 13170847.1
(22) Date of filing: 06.06.2013
(51) Int. Cl.: H01L 33/60

(54) **Light reflecting member for optical semiconductor, and substrate for mounting optical semiconductor and optical semiconductor device using the light reflecting member**

(30) Priority: 06.06.2012 JP 2012129073; 22.03.2013 JP 2013060065
(71) Applicant: NITTO DENKO CORPORATION, Osaka 567 (JP)
(72) Inventor: Fuke, Kazuhiro, Ibaraki-shi, Osaka 567-8680 (JP); Ooyabu, Yasunari, Ibaraki-shi, Osaka 567-8680 (JP)
(74) Representative: Grünecker, Kinkeldey, Stockmair & Schwanhäusser

(57) **Abstract**

The present invention relates to a light reflecting member for an optical semiconductor which makes it possible to manufacture a high-quality optical semiconductor device at a low cost, as well as a substrate for mounting an optical semiconductor and an optical semiconductor device using such a light reflecting member.

## Description

### FIELD OF THE INVENTION

The present invention relates to a light reflecting member for an optical semiconductor which makes it possible to manufacture a high-quality optical semiconductor device at a low cost, as well as a substrate for mounting an optical semiconductor and an optical semiconductor device using such a light reflecting member.

### BACKGROUND OF THE INVENTION

In recent years, optical semiconductor devices such as LEDs (light-emitting diodes) have come to be used widely in illumination equipment and as backlights of PC monitors, liquid crystal TV receivers, etc. An optical semiconductor device used for these purposes is implemented as a module in such a manner that an individual SMD (surface mount device) such as a PLCC (plastic leaded chip carrier) is mounted on a circuit board.

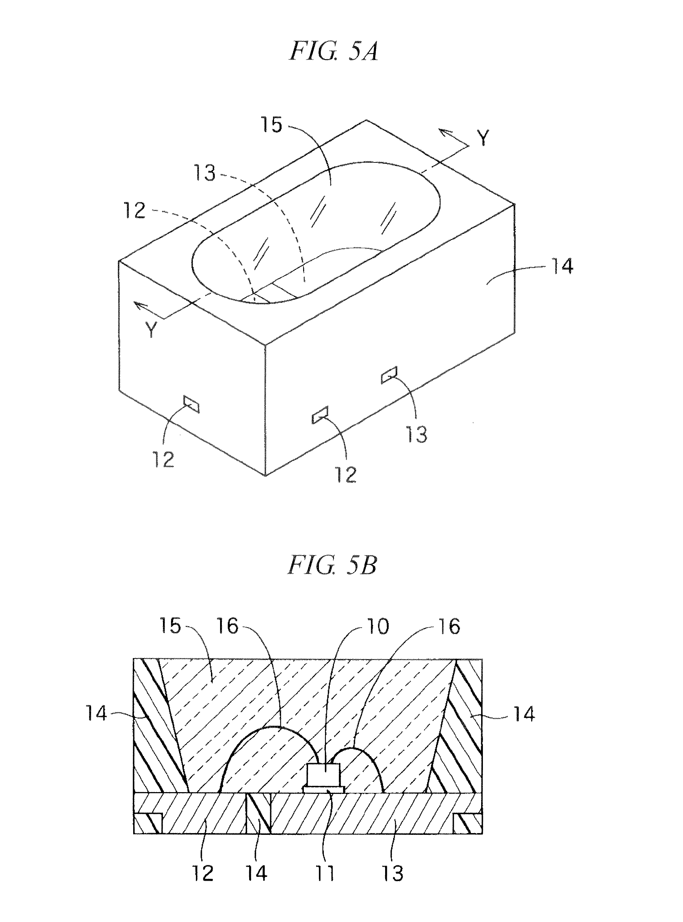

Figs. 5A and 5B (a sectional view taken along line Y-Y in Fig. 5A) shows the structure of an example of such an SMD package. In this SMD package, an optical semiconductor element 10 is mounted, via an adhesive layer 11, on a lead frame 13 for electrical connections to the outside, and a reflector 14 is disposed so as to surround the optical semiconductor element 10, The space surrounded by the reflector 14 is filled with an encapsulating material 15. In Figs. 5A and 5B, reference numeral 12 denotes a lead frame that is opposite in polarity to the lead frame 13 and numeral 16 denotes bonding wires for electrical connections to the respective lead frames 12 and 13.

Conventionally, a thermoplastic resin such as a polyamide resin has been used as a material of the reflector 14. However, now there is concern about its durability because of, for example, temperature increase due to increased generation of heat due to recent increase in the luminance of optical semiconductor elements. As a countermeasure, the applicant of the present application has already proposed using, as the reflector 14, a cured body of a special epoxy resin composition which is superior in heat resistance and light reflectivity (refer to Patent document 1).

Incidentally, in the case where a thermosetting resin such as an epoxy resin is used as a material of the reflector, an LED module can be manufactured by a process including the following steps. First, a reflector 14 having a prescribed shape is resin-formed on lead frames 12 and 13 using a thermosetting resin forming machine of a compression molding or transfer molding type. Then, resin burrs that were formed on the back surface of a substrate during the resin formation are removed as appropriate by a mechanical method such as blasting or a chemical method such as electrolysis. Then, an optical semiconductor element 10 is mounted, via an adhesive layer 11, on the lead frame 13 in the space that is surrounded by the reflector 14. At this time, the optical semiconductor element 10 is electrically connected to the lead frames 12 and 13 by bonding wires 16. Then, the optical semiconductor element 10 is encapsulated with a transparent encapsulating material 15 such as an epoxy resin or a silicone resin, to form an SMD package. Individual SMD packages may be formed by cutting a structure including them at prescribed positions with a dicer or the like. An LED module to be used in an illumination apparatus or as a backlight can be completed by mounting the thus-produced SMD package on a module board by IR reflow or the like.

However, the above-mentioned manufacturing method in which the number of steps is larger than that of manufacturing methods of conventional packages which use a thermoplastic resin as a material of the reflector, is not only complicated but also may increase the manufacturing cost to a large extent.

One countermeasure method against the above-mentioned problem which arises in the case where a thermosetting resin is used as a material of the reflector is proposed in Patent document 2. In this method, a semi-cured (i.e., being at a B-stage) sheet which is made of a thermosetting resin composition and is to be used for formation of a reflector is produced. The sheet is compression-bonded to an optical semiconductor element mounting surface of a substrate and then heated to cure completely. In this manner, a reflector is directly joined to the substrate.

Patent document 1: JP-A-2011-258845
Patent document 2: Japanese Patent No. 4,754,850

### SUMMARY OF THE INVENTION

However, although the method of Patent document 2 is simple, it has been found that this method raises the following two new problems. First, the sheet may be deformed due to pressing or heating when it is compression-bonded to the substrate. Second, since the sheet needs to be kept a semi-cured state until joining to the substrate, it should be stored in a cooling facility such as a freezer to delay the progress of curing. Thus, development of an even superior method is desired.

The present invention has been made to solve the above-mentioned problems, and an object of the present invention is to provide a light reflecting member for an optical semiconductor which, by virtue of its special structure, can be manufactured at a low cost and can efficiently output light emitted from an optical semiconductor element because a resin formed body is prevented from being distorted even when pressurized or heated, as well as a substrate for mounting an optical semiconductor and an optical semiconductor device using such a light reflecting member.

In order to attain the object above, the present invention relates to the following items (1) to (8).
(1) A light reflecting member for an optical semiconductor, which is to be joined to an optical semiconductor element mounting surface of a substrate, including:
   a resin formed body having a through-hole that penetrates through the resin formed body in a top-bottom direction and whose inner circumferential surface is colored in white; and
   a joining layer containing a white pigment, which is formed on a bottom surface of the resin formed body,
   in which the light reflecting member is configured so as to be joined to the substrate via the joining layer containing a white pigment in a state that a portion to be mounted with an optical semiconductor element or an optical semiconductor element mounted portion on the substrate is positioned so as to be located in an opening of the through-hole; and
   the light reflecting member is configured so that when the optical semiconductor element is mounted in the opening of the through-hole, light emitted from the optical semiconductor element is reflected by the inner circumferential surface of the through-hole.
(2) The light reflecting member for an optical semiconductor according to item (1), in which the resin formed body is a cured body of a thermosetting resin composition comprising, as a main component, at least one resin selected from the group consisting of an epoxy resin, a silicone resin, a urethane resin, a urea resin, a phenol resin and a melamine resin.
(3) The light reflecting member for an optical semiconductor according to item (1) or (2), in which the white pigment is at least one compound selected from the group consisting of titanium oxide, zinc oxide, aluminum oxide, magnesium oxide, zirconium oxide, calcium carbonate, barium carbonate and barium sulfate.
(4) The light reflecting member for an optical semiconductor according to any one of items (1) to (3), in which the resin formed body is formed by transfer molding, compression molding, injection molding or casting molding.
(5) The light reflecting member for an optical semiconductor according to any one of items (1) to (4), in which the through-hole is filled with a B-stage transparent resin.
(6) The light reflecting member for an optical semiconductor according to item (5), in which the B-stage transparent resin is a silicone resin.

(7) A substrate for mounting an optical semiconductor, including:
   a substrate; and
   the light reflecting member for an optical semiconductor according to any one of items (1) to (4) which is joined to the substrate,
   in which the portion to be mounted with an optical semiconductor element of the substrate is positioned so as to be located in the opening of the through-hole of the light reflecting member.
(8) An optical semiconductor device including:
   a substrate;
   the light reflecting member for an optical semiconductor according to any one of items (1) to (7) which is joined to and integrated with the substrate;
   an optical semiconductor element which is mounted in the opening of the through-hole of the light reflecting member; and
   a transparent resin which encapsulates the through-hole.

The present inventors studied diligently to manufacture a highly heat-resistant optical semiconductor device at a low cost with as small a number of steps as possible. The inventors completed the invention by finding that light emitted from an optical semiconductor element is prevented from being absorbed by a joining layer existing between a reflector and a substrate, whereby light extraction efficiency can be increased by increasing the heat resistance of an optical semiconductor device by using a cured body of a thermosetting resin as a reflector of the optical semiconductor device and joining the resin cured body to a substrate via a joining layer containing a white pigment.

In the invention, the term "colored in white" means that a color that originates from the white pigment appears.

In the invention, the term "transparent resin" means not only a resin that is colorless and transparent but also a resin that is colored and transparent. The term "transparent" means a state that enables passage of light that allows an optical semiconductor device to exercise its required capability. As long as this requirement is satisfied, the degree of transparency is not an issue.

In the invention, the term "main component" means a component that accounts for more than half of the whole and also includes the case where the whole consists of the main component.

Furthermore, in the invention, the term "substrate" means a plate-like member on which a functional component for realizing a function is to be mounted and which may be either rigid or flexible and is not restricted in thickness. Therefore, this term also encompasses a flexible pressure-sensitive adhesive sheet.

As described above, the light reflecting member for an optical semiconductor according to the invention includes a resin formed body having a through-hole that penetrates through the resin formed body in the top-bottom direction and a joining layer containing a white pigment, which is formed on the bottom surface of the resin formed body. The light reflecting member is joined to the optical semiconductor element mounting surface of a substrate via the joining layer containing a white pigment. Therefore, the reflector, which is the resin formed body can be joined to the substrate without requiring complicated steps or a complicated facility. Furthermore, since the joining layer containing a white pigment can easily conform to unevenness due to a conductor circuit formed on the substrate, the resin formed body can be joined to the substrate while deformation of the resin formed body is suppressed. In addition, since the joining layer which exists between the reflector and the substrate contains a white pigment, light emitted from an optical semiconductor element can also be reflected by the joining layer with no loss. As a result, the optical semiconductor device using the light reflecting member for an optical semiconductor according to the invention is highly resistant to heat, is high in luminance, and can be manufactured at a low cost.

In the case where the resin formed body is a cured body of a thermosetting resin composition including, as a main component, at least one resin selected from the group consisting of an epoxy resin, a silicone resin, a urethane resin, a urea resin, a phenol resin and a melamine resin, even high heat resistance and durability can be attained.

In the case where the white pigment is at least one compound selected from the group consisting of titanium oxide, zinc oxide, aluminum oxide, magnesium oxide, zirconium oxide, calcium carbonate, barium carbonate and barium sulfate, the light reflection efficiency can be increased at an even lower cost.

In the case where the resin formed body is formed by transfer molding, compression molding, injection molding, or casting molding, it can be given a more accurate shape and hence the light extraction efficiency can be increased further.

In the case where the through-hole of the resin formed body is filled with a B-stage transparent resin, it is not necessary to separately prepare a transparent resin for encapsulating the optical semiconductor element and hence the optical semiconductor device can be manufactured efficiently.

In the case where the B-stage transparent resin is a silicone resin, the portion for encapsulating the optical semiconductor element is made superior in light resistance, heat resistance, and storage stability and hence the life of the optical semiconductor device can be elongated.

Furthermore, the substrate for mounting an optical semiconductor in which the light reflecting member for an optical semiconductor according to the invention is joined to a substrate and a portion to be mounted with an optical semiconductor element of the substrate is positioned so as to be located in an opening of the through-hole of the light reflecting member makes it possible to manufacture a high-performance optical semiconductor device at a low cost.

The optical semiconductor device in which the light reflecting member for an optical semiconductor according to the invention is joined to and integrated with a substrate, an optical semiconductor element is mounted in the opening of the through-hole of the light reflecting member, and the through-hole is filled with a transparent resin is highly resistant to heat, is high in luminance, and can be manufactured at a low cost.

### BRIEF DESCRIPTION OF THE DRAWING

Fig. 1 is a perspective view showing an appearance of a light reflecting member for an optical semiconductor according to an embodiment of the present invention.
Fig. 2 is a sectional view, taken along line X-X in Fig. 1, of the light reflecting member for an optical semiconductor.
Fig. 3 is a sectional view of part of a substrate for mounting an optical semiconductor according to an embodiment of the invention.
Fig. 4 is an optical semiconductor device according to an embodiment of the invention.
Fig. 5A is a perspective view showing an appearance of a conventional optical semiconductor device, and Fig. 5B is a sectional view taken along line Y-Y in Fig. 5A.
Fig. 6 is a perspective view showing an appearance of a light reflecting member for an optical semiconductor according to another embodiment of the invention.
Fig. 7 is a sectional view, taken along line Z-Z in Fig. 6, of the light reflecting member for an optical semiconductor.
Fig. 8 illustrates a method for manufacturing the light reflecting member for an optical semiconductor of Fig. 6.

### DETAILED DESCRIPTION OF THE INVENTION

Embodiments of the present invention will be described below.

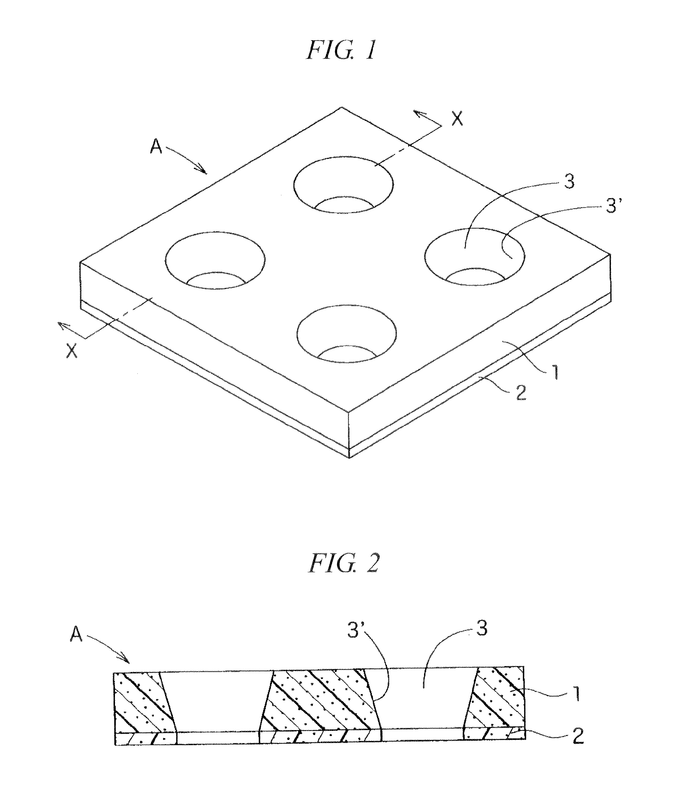

Fig. 1 shows a light reflecting member A for an optical semiconductor according to an embodiment of the invention. Fig. 2 is a sectional view taken along line X-X in Fig. 1. The light reflecting member A for an optical semiconductor is shaped like a sheet and measures 70 mm in width, 70 mm in length, and 0.60 mm in thickness, and has a resin formed body 1 containing a white pigment (hereinafter, simply referred to as resin formed body) and a joining layer 2 containing a white pigment which is formed on the bottom surface of the resin formed body 1. Four through-holes penetrate through the resin formed body 1 in the top-bottom direction. In Fig. 1, the size, shape, thickness, etc. of each portion are shown schematically and are different from those of an actual one (this also applies to the other drawings to be referred to below).

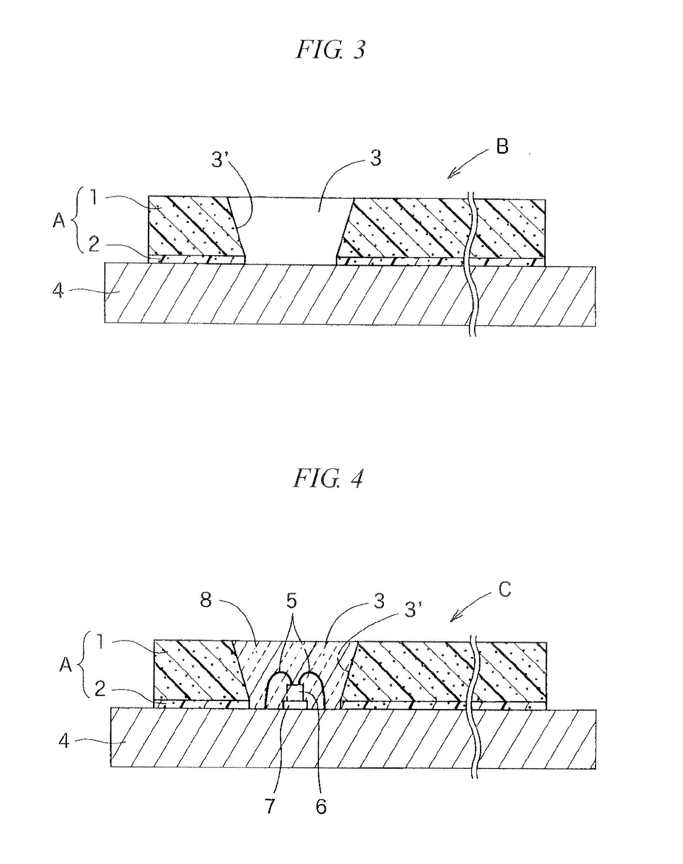

As described later, a substrate B for mounting an optical semiconductor can be produced by joining the light reflecting member A for an optical semiconductor (actually, its joining layer 2 containing a white pigment) to a substrate 4 in a state that a portion to be mounted with an optical semiconductor on the substrate 4 is positioned so as to be located in the opening of the through-hole 3 (see Fig. 3). Furthermore, an optical semiconductor device C in which light emitted from the optical semiconductor element 6 is reflected by the inner circumferential surface 3' of the through-hole 3 and taken from the top opening of the through-hole 3, can be produced by mounting the optical semiconductor element 6 in the opening of the through-hole 3 of the substrate B for mounting an optical semiconductor (see Fig. 4). The optical semiconductor device C can also be produced by joining, via a joining layer 2 containing a white pigment, the light reflecting member A for an optical semiconductor to a substrate 4 that is mounted with optical semiconductor elements 6 in advance, in a state that the optical semiconductor element 6 mounted portion is positioned so as to be located in the opening of the through-hole 3.

In order to increase the light reflectivity, the resin formed body 1 of the light reflecting member A for an optical semiconductor is a cured body of a thermosetting resin composition containing titanium oxide (average particle diameter: 0.21 µm) as a white pigment. The thermosetting resin composition includes an epoxy resin as the main component. The resin formed body 1 is 0.50 mm in thickness.

The joining layer 2 containing a white pigment is made of a silicone-based pressure-sensitive adhesive added with titanium oxide (average particle diameter: 0.21 µm). Light emitted from the optical semiconductor element 6 is also reflected by the joining layer 2 containing a white pigment; that is, the light is prevented from leaking out through the joining layer 2. The joining layer 2 is 0.10 mm in thickness. As shown in Fig. 2, each through-hole 3 is cone-shaped so as to increase in diameter as the position goes upward so that light emitted from the optical semiconductor element 6 is taken efficiently through the top opening of the through-hole 3.

For example, the light reflecting member A for an optical semiconductor can be manufactured in the following manner. First, a thermosetting resin composition for forming a resin formed body 1 is prepared. More specifically, a thermosetting resin composition containing a white pigment is produced by adding, to an epoxy resin, titanium oxide and, if necessary, any of other materials such as a curing agent, a curing accelerator, a curing catalyst, a polymerization initiator, a light stabilizer, an antioxidant, a denaturant, a mold release agent, a filler, a coupling agent, a leveling agent, and a flame retardant and melt-blending them using a double roll type blender, for example.

Then, the thermosetting resin composition is shaped into a resin formed body 1 having the shape shown in Figs. 1 and 2 by transfer molding. More specifically, a resin formed body 1 having such a shape is produced by injecting the thermosetting resin composition that is heated to about 200°C into a die retaining a cavity that conforms to the intended shape and curing the thermosetting resin composition. Alternatively, the resin formed body 1 as subjected to the transfer molding may be heated to completely curing.

On the other hand, a composition for forming a joining layer 2 containing a white pigment is prepared. More specifically, titanium oxide is added to a silicone-based pressure-sensitive adhesive and they are blended together uniformly. A joining layer 2 containing a white pigment is produced by coating the bottom surface of the resin formed body 1 so as to be an arbitrary thickness. It is preferable that a liner (not shown) is bonded to the bottom surface (i.e., the surface that is not in contact with the resin formed body 1) of the joining layer 2 containing a white pigment, to prevent adhesion of foreign substances to the bottom surface.

In the above-configured light reflecting member A for an optical semiconductor, since the resin formed body 1 which is superior in heat resistance is joined to a substrate via the joining layer 2 containing a white pigment (titanium oxide), no complicated steps or facility is necessary for joining of the light reflecting member A to a substrate. And the light reflecting member A can be joined to a substrate by merely peeling the liner and placing the thus-exposed bottom surface of the joining layer 2 on the substrate while a portion to be mounted with an optical semiconductor element or an optical semiconductor element mounted portion is positioned. Therefore, unlike in conventional light reflecting members, the resin formed body 1 (reflector) is not deformed due to, for example, pressing with heating. Therefore, light emitted from an optical semiconductor element can be reflected as calculated. Furthermore, since the resin formed body 1 which contains the white pigment and in which the inner circumferential surface 3' of the through-hole 3 has a white color is joined to a substrate by the joining layer 2 containing a white pigment (titanium oxide), light emitted from an optical semiconductor element is not absorbed by the joining layer 2 and, instead, is reflected with no loss and taken from the top opening of the through-hole 3. Still further, since the resin formed body 1 is produced by transfer molding, it is given a more accurate shape and hence optical semiconductor devices using the resin formed body 1 should exhibit high performance.

Whereas the above-described resin formed body 1 is made of a thermosetting resin composition having an epoxy resin as the main component, any of other thermosetting resins such as a silicone resin, a urethane resin, a urea resin, a phenol resin, and a melamine resin may be used as the main component. The resin formed body 1 may be made of a composition other than a thermosetting resin composition, such as a composition having, as the main component, a photo-curing resin such as a thiol-ene resin, a thermoplastic resin such as a polyamide resin, a polyester resin, or a liquid crystal polymer resin, or rubber. From the viewpoints of high resistance to color change due to heating and high stability against exposure to light, it is preferable to use a composition having, as the main component, among the above materials, a thermosetting resin, in particular, an epoxy resin, a silicone resin, a urethane resin, a urea resin, a phenol resin, or a melamine resin. The above materials may be used alone or as a combination of two or more thereof.

Whereas the above-described resin formed body 1 contains titanium oxide as the white pigment, another material that is different in refractive index from the resin, the curing agent, and the curing accelerator as components of the resin composition of the resin formed body 1 may be used as the white pigment. Example materials that exhibit larger refractive indexes than those components of the resin composition are titanium oxide, zinc oxide, aluminum oxide, magnesium oxide, antimony oxide, zirconium oxide, white lead, kaolin, alumina, calcium carbonate, barium carbonate, barium sulfate, zinc sulfate, and zinc sulfide. Example materials that exhibit smaller refractive indexes than those components of the resin composition are hollow particles of silica, soda glass, borosilicate glass, and alkali-free glass. From the viewpoint of high reflectivity which results from a large refractive index difference from those components of the resin composition, it is preferable to use titanium oxide, zinc oxide, aluminum oxide, magnesium oxide, zirconium oxide, calcium carbonate, barium carbonate, or barium sulfate. The above materials may be used alone or as a combination of two or more thereof, In the case where the inner circumferential surface 3' of the through-hole 3 is colored in white by coating with a paint containing a white pigment, it is not necessary that the resin composition contain the above-described white pigment.

When any of the above materials is used as the white pigment, in order to efficiently reflect light emitted from the optical semiconductor element 6, it is preferable that the amount of the white pigment is 0.1 to 80 parts by weight based on 100 parts by weight of the other components of the resin composition. It is particularly preferable that the amount of the white pigment amount is 1 to 50 parts by weight. Although the particle diameter of the white pigment may be set at an arbitrary value, in order to enable uniform mixing into the thermosetting resin composition, it is particularly preferable that the average particle diameter of the white pigment is in a range of 0.01 to 10 µm. The average particle diameter is obtained by measuring particle diameters of samples extracted from a population using a laser diffraction/scattering particle size distribution analyzer and calculating an average value thereof.

Although in the above manufacturing method the resin formed body 1 is 0.50 mm in thickness, the thickness thereof is not limited to this value and may be an arbitrary value. It is preferable that the thickness of the resin formed body 1 is in a range of 0.15 to 3.0 mm. And it is more preferable that the thickness is in a range of 0.20 to 2.0 mm.

Although in the above manufacturing method the through-hole 3 formed through the resin formed body 1 is approximately circular in a plan view, it may have any of other shapes. It is preferable that the through-hole 3 is not angled, that is, corners thereof are rounded. In order to increase the light reflectivity, it is preferable that the through-hole 3 has an approximately circular, approximately elliptical, or the like shape. Furthermore, although a total of four through-holes 3 (two in each of two rows) are arranged in the resin formed body 1, the number and the manner of arrangement of through-holes 3 are not limited to those of the above-described resin formed body 1 and may be set according to the arrangement of the optical semiconductor elements 6 mounted in the respective through-holes 3. Only one through-hole 3 may be formed. Still further, as for the shape of the inner circumferential surface 3' of the through-hole 3, it is not necessarily straight in cross section, that is, it may be curved in cross section.

Although in the above manufacturing method the resin formed body 1 is formed by transfer molding, it may be formed by another molding method such as compression molding, casting molding, or injection molding. The resin formed body 1 can also be produced by cutting a plate-like body or laminating thin, punched-out bodies. However, to produce a resin formed body 1 having a more accurate shape, it is preferable that the resin formed body 1 is formed by transfer molding, compression molding, casting molding, or injection molding.

In order to increase the strength of joining of the joining layer 2 containing a white pigment to the resin formed body 1, a portion of the resin formed body 1 which is to be come into contact with the joining layer 2 may be surface-roughened in advance by filing, blasting, or the like. The strength of joining of the joining layer 2 to the resin formed body 1 can also be increased by a surface cleaning treatment using a liquid chemical, plasma, or the like or a primer treatment such as application of a silane coupling agent.

In the above manufacturing method, the entire resin formed body 1 including the inner circumferential surface 3' of the through-hole 3 is colored in white by adding a white pigment to a resin composition in advance and then molding the resin composition. Alternatively, the inner circumferential surface 3' of the through-hole 3 of the resin formed body 1 may be colored in white by applying a paint containing a white pigment to the inner circumferential surface 3'. In particular, in the case where the resin formed body 1 is formed by cutting a plate-like body or laminating thin, punched-out bodies, it is preferable to color the inner circumferential surface 3' of the through-hole 3 using a paint containing a white pigment. The paint containing a white pigment may be applied to not only the inner circumferential surface 3' of the through-hole 3 but also other portions of the resin formed body 1; for example, the paint containing a white pigment may be applied to all the surfaces of the resin formed body 1. The white pigment contained in the paint may be the same as that used in the resin formed body 1.

Although in the above manufacturing method the joining layer 2 containing a white pigment is made of a silicone-based pressure sensitive adhesive-based composition containing a white pigment, the base material of the composition containing a white pigment is not limited to a silicone-based pressure sensitive adhesive and may be an arbitrary pressure sensitive adhesive. It is preferable to use a pressure sensitive adhesive whose storage modulus is in a range of 10 kPa to 100 MPa (even preferably, 10 kPa to 10 MPa). An adhesive may be used in stead of such a pressure sensitive adhesive. In the case where the joining layer 2 containing a white pigment is made of an adhesive-based composition containing a white pigment, it is preferable to use, as a base material, an adhesive that is cured when heated to a temperature in a range of ordinary temperature to 200°C or an adhesive (e.g., acrylate-based adhesive, methacrylate-based adhesive, or epoxy-based adhesive) that is cured when irradiated with electromagnetic waves such as ultraviolet light or visible light.

Although in the above manufacturing method titanium oxide is used as the white pigment contained in the joining layer 2, the other white pigments that can be contained in the resin formed body 1 may also be contained in the joining layer 2 at the same preferable content as contained in the resin formed body 1. However, the white pigment contained in the joining layer 2 is not necessarily the same as that contained in the resin formed body 1 and may be determined as appropriate according to the kind of a base pressure-sensitive adhesive or adhesive.

Although in the above manufacturing method the joining layer 2 containing a white pigment is 0.10 mm in thickness, the thickness thereof is not limited to this value and may be an arbitrary value. It is preferable that the thickness of the joining layer 2 containing a white pigment is in a range of 1 to 200 µm. And it is more preferable that the thickness thereof is in a range of 5 to 100 µm.

Although in the above manufacturing method the joining layer 2 containing a white pigment is formed by applying a composition containing a white pigment to the bottom surface of the resin formed body 1, it may be formed by another, arbitrary method. For example, the joining layer 2 containing a white pigment may be formed in the following manner. A joining layer sheet is produced by forming a joining layer 2 containing a white pigment, which comprises a composition containing a white pigment on a separately prepared liner, and is bonded to the bottom surface of the resin formed body 1 using the joining layer 2 containing a white pigment. Then, portions corresponding to the respective through-holes 3 are removed by punching or the like. Alternatively, the joining layer 2 containing a white pigment may be formed in the following manner. Through-holes are formed in advance in the above joining layer sheet so as to conform to the respective through-holes 3. The resulting joining layer sheet is bonded to the bottom surface of the resin formed body 1 using the joining layer 2 containing a white pigment while being positioned with respect to the resin formed body 1.

The size and shape of the light reflecting member A for an optical semiconductor are determined as appropriate. However, for ordinary uses, it is preferable that the light reflecting member A is in a sheet form and has a size of 2 to 200 mm in width and 2 to 2,500 mm in length, because manufacture of a substrate B for mounting an optical semiconductor having a prescribed size takes time and labor if the light reflecting member A is too small and alternatively, the light reflecting member A is difficult to handle if it is too large.

For example, the substrate 13 for mounting an optical semiconductor according to the invention (see Fig. 3) can be manufactured in the following manner using the above-described light reflecting member A for an optical semiconductor.

First, an aluminum substrate 4 is prepared. An insulating layer (not shown) is formed on the surface of the substrate 4 and a conductor circuit for connections to optical semiconductor elements, an external power source, etc. is formed on the insulating layer. To protect the conductor circuit and increase the extraction efficiency of light emitted from the optical semiconductor element, portions other than portions to be connected to an external power source etc. and portions to be mounted with optical semiconductor elements are coated with a resin cured body made of the same material as the resin formed body 1.

A substrate B for mounting an optical semiconductor can be produced by bringing the light reflecting member A for an optical semiconductor (actually, its joining layer 2 containing a white pigment) into close contact with the substrate 4 in a state that portions, to be mounted with optical semiconductors, of the substrate 4 are positioned so as to be located in the respective through-holes 3 of the light reflecting member A, and then joining the light reflecting member A to the substrate 4 by pressing them against each other using a press machine or the like.

Examples, other than an aluminum substrate, of the substrate 4 are a metal substrate made of, for example, copper, iron, an alloy thereof, an organic substrate made of, for example, an epoxy resin impregnated with glass fiber, a flexible printed circuit board, and a ceramic substrate. In the case where the substrate 4 is insulative, it is not necessary to form the above-mentioned insulating layer. Although it was stated that the portions other than the portions to be connected to an external power source etc. and the portions to be mounted with optical semiconductor elements are coated with the resin cured body made of the same material as the resin formed body 1, those portions may be coated with a different material from the resin formed body 1. If it is not necessary to achieve the protection or the like of the conductor circuit, the coating of those portions is not necessary.

The light reflecting member A may be joined to the substrate 4 using an autoclave or the like instead of a press machine. In the case where a press machine is used, it is preferable to set the pressure at 1 Pa to 100 MPa (more preferably, 10 Pa to 50 MPa). This is because the light reflecting member A or the substrate 4 may be deformed or damaged if the load is too heavy and the light reflecting member A may not be brought into sufficiently close contact with the substrate 4 if the load is too light.

It is preferable that the strength of joining of the joining layer 2 containing a white pigment to the substrate 4 is in a range of 10 kPa to 100 MPa in terms of joining shear strength (more preferably, 20 kPa to 50 MPa). The reasons are as follows. If the joining shear strength is too low, problems such as that the joining position deviates easily likely occur. Conversely, if the joining shear strength is too high, it is very difficult to remove the light reflecting member A for an optical semiconductor when it was joined to the substrate 4 at a wrong position. The joining shear strength is a value that is obtained by joining the substrate B for mounting an optical semiconductor is joined to a stainless steel plate and measuring a force that is necessary to separate the resin formed body 1 from the substrate 4 when shearing force is applied between them in the direction that is parallel with their joining surface.

For example, the optical semiconductor device C according to the invention (see Fig. 4) can be manufactured in the following manner using the above-described substrate B for mounting an optical semiconductor.

Optical semiconductor element 6 is placed in the opening of the through-hole 3 of the substrate B for mounting an optical semiconductor, and bonded and fixed to the substrate 4 by adhesive layer 7 made of a die attach agent. And the optical semiconductor element 6 is electrically connected to the above-mentioned conductor circuit by bonding wires, whereby the optical semiconductor element 6 is mounted on the substrate B. An optical semiconductor device C is obtained by encapsulating the recesses formed by the through-hole 3 and the substrate 4 with a transparent resin 8.

An optical semiconductor device C can also be produced by bringing the light reflecting member A for an optical semiconductor (actually, a joining layer 2 containing a white pigment) into close contact with a substrate 4 that is mounted with optical semiconductor elements 6 in advance, in a state that the optical semiconductor element 6 mounted portion is positioned so as to be located in the opening of the through-hole 3, pressing them against each other using a pressing machine or the like, and then encapsulating the recess formed by the through-hole 3 and the substrate 4 with a transparent resin 8.

In the optical semiconductor device C, unlike in conventional ones, the resin formed body 1 (reflector) can reflect light emitted from the optical semiconductor element 6 as calculated because the resin formed body 1 has not been deformed due to, for example, pressing with heating. Furthermore, since the resin formed body 1 is joined to the substrate 4 by the joining layer 2 containing a white pigment (titanium oxide), light emitted from the optical semiconductor element 6 is not absorbed by the joining layer 2 and, instead, is reflected with no loss and taken from the top opening of the through-hole 3. Therefore, high luminance can be realized. Still further, since the resin formed body 1 is produced by transfer molding, it is given a more accurate shape and hence optical semiconductor device C using the resin formed body 1 should exhibit high performance.

The optical semiconductor elements 6 may be mounted by a flip-chip method. The substrate B for mounting an optical semiconductor may be cleaned by a plasma treatment before mounting of the optical semiconductor element 6. The transparent resin 8 may contain a phosphor, a filler or the like according to the necessity.

The optical semiconductor device C may be mounted with lenses according to the necessity. The optical semiconductor device C may be cut by dicing or the like into necessary units, for example, units corresponding to the respective optical semiconductor elements 6 to produce optical semiconductor devices.

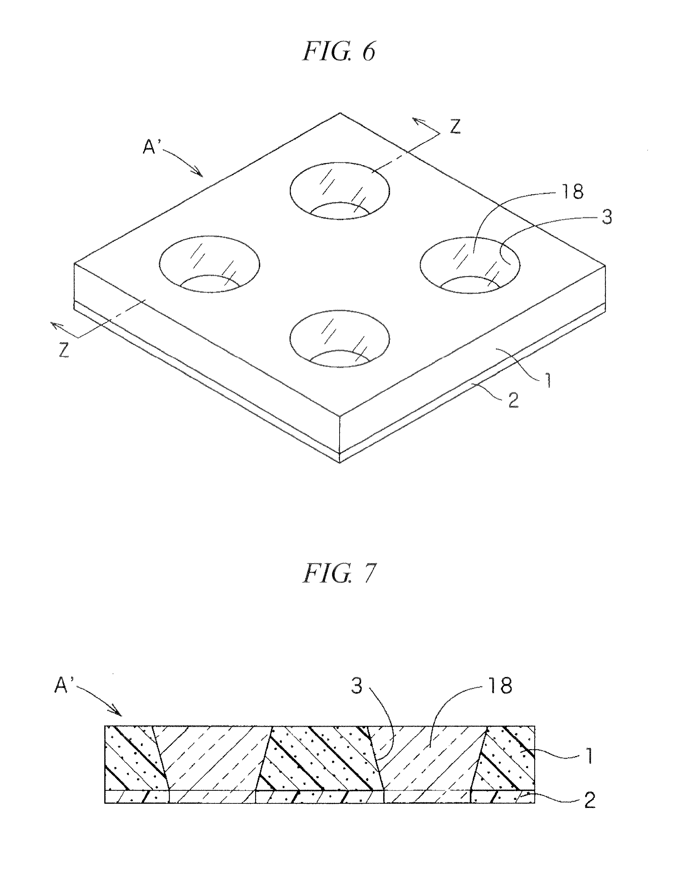

In the invention, the through-hole 3 of the light reflecting member A for an optical semiconductor may be filled with a B-stage transparent resin 18. Fig. 6 shows such a light reflecting member A' for an optical semiconductor. Fig. 7 is a sectional view taken along line Z-Z in Fig. 6. That is, the light reflecting member A' for an optical semiconductor is such that the through-hole 3 of the resin formed body 1 of the light reflecting member A for an optical semiconductor shown in Fig. 1 are filled with the B-stage transparent resin 18. The light reflecting member A' for an optical semiconductor will not be described in detail because it is the same as the light reflecting member A for an optical semiconductor in the other respects. The transparent resin 18 may contain a phosphor, a filler or the like according to the necessity.

In the invention, a transparent resin (which is a thermosetting resin) being at the B-stage means that it is at an intermediate stage between the A-stage at which it is soluble in a solvent and the C-stage at which it is completely cured, and hence is in a state that it has slightly undergone curing and gelling, it swells in a solvent but does not completely dissolved therein, and it softens but does not melt when heated.

It is preferable that the B-stage transparent resin 18 is a B-stage state of a thermosetting resin composition including, as a main component, at least one resin selected from the group consisting of a silicone resin, an epoxy resin, and a urethane resin. It is more preferable to use a B-stage state of a thermosetting resin composition including a silicone resin as a main component because it is superior in light resistance, heat resistance, and storage stability. Such a thermosetting resin may contain a phosphor, a filler or the like according to the necessity.

Examples of the silicone resin usable include a two-step curing silicone resin and a one-step curing silicone resin, and of these, the two-step curing silicone resin is preferable. The two-step curing silicone resin is a thermosetting silicone resin having a two-step reaction mechanism. A first-step reaction brings it into the B-stage (semi-cured state), and a second-step reaction brings it into the C-stage (completely-cured state). An example of the two-step curing silicone resin is a condensation reaction-addition reaction curing silicone resin which has two reaction systems, that is, a condensation reaction system and an addition reaction system. An example of the condensation reaction-addition reaction curing silicone resin is a silicone resin composition disclosed in JP-A-2013-023603 which includes (1) organopolysiloxane having at least two alkenylsilyl groups in one molecule thereof, (2) organopolysiloxane having at least two hydrosilyl groups in one molecule thereof, (3) a hydrosilylation catalyst, and (4) a curing retarder. On the other hand, the one-step curing silicone resin is a thermosetting silicone resin having a one-step reaction mechanism which is cured completely by the one-step reaction.

The above-mentioned phosphor is a substance having a wavelength conversion function. Examples of the phosphor include a yellow phosphor capable of converting blue light into yellow light and a red phosphor capable of converting blue light into red light, and of these, the yellow phosphor is preferable. Examples of the yellow phosphor include garnet phosphors having the garnet crystal structure such as Y₃Al₅O₁₂: Ce (YAG (yttrium aluminum garnet): Ce) and Tb₃Al₃O₁₂: Ce (TAG (terbium aluminum garnet): Ce) and oxynitride phosphors such as Ca-α-SiAlON. Examples of the red phosphor include nitride phosphors such as CaAlSiN₃: Eu and CaSiN₂: Eu.

Examples of shapes of phosphor particles include a sphere, a plate-like shape, and a needle-like shape, among which the spherical shape is preferable because it provides high flowability. It is preferable that the average of phosphor particle maximum lengths (average particle diameter in the case of the spherical shape) is in a range of 0.1 to 200 µm. A range of I to 100 µm is more preferable. It is preferable that the content of the phosphor is 0.1 to 80 parts by mass based on 100 parts by mass of the thermosetting resin composition. A range of 0.5 to 50 parts by mass is more preferable.

Examples of the above-mentioned filler include organic fine particles such as silicone particles and inorganic fine particles such as silica, talc, alumina, aluminum nitride, silicon nitride, etc. It is preferable that the content of the filler is 0.1 to 70 parts by mass based on 100 parts by mass of the thermosetting resin composition. A range of 0.5 to 50 parts by mass is more preferable.

With the above structure, when the light reflecting member A' for an optical semiconductor (actually, its joining layer 2 containing a white pigment) is joined to the substrate 4, the B-stage transparent resin 1 in the opening of the through-hole 3 of the light reflecting member A' for an optical semiconductor is easily deformed so as to conform to the corresponding optical semiconductor element 6 mounted on the substrate 4, thereby surrounding the optical semiconductor element 6 smoothly. Then, the B-stage transparent resin 18 is subjected to heating or the like and thereby brought into the C-stage (completely curing) to become transparent resin 8. Thus, an optical semiconductor device C in which the optical semiconductor element 6 is encapsulated with the transparent resin 8 is produced. In the case where as described above the optical semiconductor device C is manufactured using the light reflecting member A' for an optical semiconductor in which the opening of the through-hole 3 is filled with the B-stage transparent resin 18 in advance, an advantages is obtained that it is not necessary to separately prepare a transparent resin 8 for encapsulating with the optical semiconductor element 6 and the light reflecting member A' for an optical semiconductor is thus easy to use, in addition to the same advantages as provided by the light reflecting member A for an optical semiconductor.

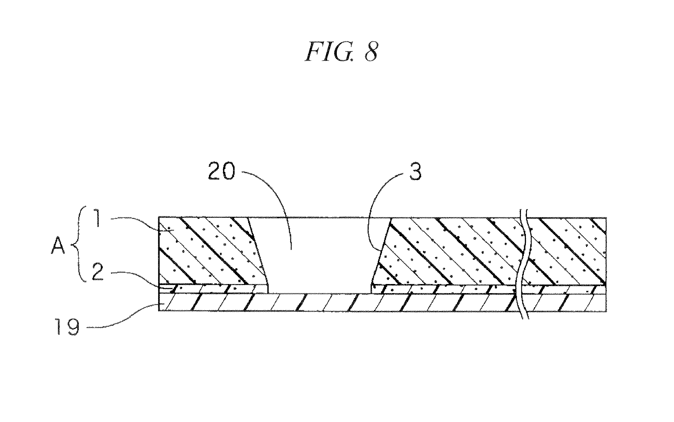

For example, the light reflecting member A' for an optical semiconductor can be manufactured in the following manner. First, a light reflecting member A for an optical semiconductor is manufactured by the above-described method (see Figs. 1 and 2). Then, as shown in Fig. 8, a liner 19 is adhered to the joining layer 2 containing a white pigment of the thus-manufactured light reflecting member A for an optical semiconductor. The bottom opening of the through-hole 3 is closed by the liner 19. Then, a thermosetting resin composition is charged into recesses 20 which are formed by the through-hole 3 and the liner 19 using a dispenser, a squeegee, etc. Then, the thermosetting resin composition is subjected to heating and thereby brought into the B-stage, whereby a light reflecting member A' for an optical semiconductor is obtained in which the through-hole 3 is filled with the B-stage transparent resin 18 (see Fig. 7). Fig. 7 shows a state that the liner 19 has been peeled off the bottom surface of the light reflecting member A' for an optical semiconductor. The B-stage transparent resin 18 does not fall off through the bottom openings of the through-hole 3 even without the liner 19, because as mentioned above the B-stage transparent resin 18 has a certain level of moldability.

### EXAMPLES

Next, Examples will be described together with Comparative Examples. However, the invention is not limited to the following Examples.

A light reflecting member A for optical semiconductor (see Figs. 1 and 2), a substrate B for mounting an optical semiconductor using it, and an optical semiconductor device C were manufactured and subjected to evaluation of deformation or average luminance in manners described below.

### [Example 1]

### <Manufacture of light reflecting member A for optical semiconductor>

### (Thermosetting resin composition)

A thermosetting resin composition for formation of a resin formed body 1 was produced by melt-blending the following materials using a planetary mixer:
triglycidyl isocyanurate: 100 parts by weight
hexahydrophthalic anhydride: 165 parts by weight
tetra-n-butylphosphonium-o, o-diethyl phosphorodithioate: 2 parts by weight
fused silica (average particle diameter: 45 µm): 150 parts by weight
rutile-type titanium oxide (average particle diameter: 0.21 µm): 200 parts by weight.

The above-mentioned thermosetting resin composition was cooled and solidified. The solidified composition was pulverized and then compressed into resin composition tablets. Each resin composition tablet was transfer-molded using a die having a cavity that conforms to the shape of the intended resin formed body 1 shown in Fig. 1 under the following conditions:
temperature: 180°C
clamping pressure: 20 MPa
injection pressure: 5 MPa
curing time: 2 min.
The resulting resin formed body 1 was heat-treated at 180°C for 3 hours using a hot wind dryer until it is cured completely.

Then, a composition containing a white pigment was produced by blending a silicone-based pressure sensitive adhesive (SD4580 produced by Du Pont-Toray Co., Ltd.; 100 parts by weight) and rutile-type titanium oxide (average particle diameter: 0.21 µm; 10 parts by weight) using a planetary mixer. The composition containing a white pigment was applied to the bottom surface of the above-produced resin formed body 1 to form a 100-µm-thick joining layer 2 containing a white pigment. To prevent adhesion of foreign substances, a liner (a PET film MRS50 produced by Mitsubishi Plastics, Inc.) was adhered to the entire surface, opposite to the surface that is in contact with the resin formed body 1, of the joining layer 2 containing a white pigment.

### <manufacture of substrate B for mounting optical semiconductor>

An insulating layer that was made of an epoxy resin containing alumina at 80 vol% was formed on a 2-mm-thick aluminum plate as a substrate 4, and a copper wiring circuit was formed on the insulating layer by a photolithography method. After portions to be mounted with optical semiconductor elements and portions to be connected to an external power source etc. were masked, a LED white reflective material (RPW-2000-11 produced by Tamura Corporation) was applied by screen printing and then solidified. Thus, a protective layer was formed on portions other than the portions to be mounted with optical semiconductor elements and the portions to be connected to an external power source etc.

Then, the liner of the light reflecting member A for an optical semiconductor was peeled off and the light reflecting member A (actually, its joining layer 2 containing a white pigment) was brought into close contact with the substrate 4 in a state that the portions to be mounted with optical semiconductor elements of the substrate 4 were positioned so as to be located in the respective openings of the through-holes 3. The light reflecting member A and the substrate 4 were joined to each other by pressing them against each other at 0.2 MPa using a press machine. Thus, an intended substrate B for mounting an optical semiconductor was manufactured (see Fig. 3).

### [Comparative Example 1]

A substrate for mounting an optical semiconductor was manufactured in the same manner as in Example 1 except for the following differences. Instead of the above-described resin formed body 1, a semi-cured (i.e., being at a B-stage) body having the same shape as the resin formed body 1 was formed by putting a thermosetting resin composition just melt-blended (i.e., in a melted liquid state) into the transfer molding die and cooling and solidifying it. A molded composition was not subjected to a heat treatment for completing the curing. No joining layer containing a white pigment was formed. The semi-cured body was compression-bonded to the optical semiconductor element mounting surface of a substrate 4 that was heated to 180°C in advance under compression bonding conditions that the time was 10 min and the pressure was 0.2 MPa. Then, the semi-cured body was cured completely by performing a post-heat treatment at 180°C for 3 hours using a hot wind dryer while the pressure of 0.2 MPa was maintained. The resulting resin formed was thus joined to the substrate 4 directly.

### <Deformation evaluation>

Twenty substrates for mounting an optical semiconductor were manufactured in each of Example 1 and Comparative Example 1. Their sizes (width, length, and thickness) were measured and compared with a design size (die inner dimensions). Whereas the sizes of the substrates of Example 1 were approximately the same as the design size, the sizes of the substrates of Comparative Example 1 had deformations in the thickness direction which measured 100 µm on average.

### [Example 2]

### <Manufacture of optical semiconductor device C>

Optical semiconductor elements (TR-5050 produced by Cree, Inc.) were mounted on the substrate B for mounting an optical semiconductor; that is, they were bonded and fixed to the above-described substrate B at prescribed positions in the openings of the respective through-holes by a die attach agent KER-3000-M2 produced by Shin-Etsu Chemical Co., Ltd.), and wire-bonded to the wiring circuit by gold wires (SR-25 produced by Tanaka Kikinzoku Kogyo K. K.). The recesses formed by the through-holes 3 and the substrate 4 were filled with an encapsulating agent (KER-2500 produced by Shin-Etsu Chemical Co., Ltd.) containing a phosphor (GLD(Y)-550A produced by GeneLite Inc.) at about 10 wt%. Thus, an intended optical semiconductor device C was manufactured (see Fig. 4). Individual optical semiconductor devices corresponding to the respective optical semiconductor elements were produced by cutting the optical semiconductor device C using a blade dicing machine (DFD6361 produced by DISCO Corporation; blade: B1A801-SDC320N50M51 54_{*}0.2_{*}40 produced by DISCO Corporation).

### [Comparative Example 2]

Optical semiconductor devices were manufactured in the same manner as in Example 2 except that the following substrate α for mounting an optical semiconductor was used instead of the above-described substrate B for mounting an optical semiconductor.

### (Substrate α for mounting an optical semiconductor)

The substrate α for mounting an optical semiconductor was manufactured in the same manner as in Example 1 except that no composition containing a white pigment was formed and a joining layer was formed by applying a silicone-based pressure sensitive adhesive itself to the bottom surface of the resin formed body 1.

### <Average luminance evaluation>

Twenty individual optical semiconductor devices that were manufactured in each of Example 2 and Comparative Example 2 so as to correspond to the respective optical semiconductor elements were prepared. They were caused to emit light by driving them at a constant current 150 mA, and luminance values were measured using a total luminous flux measuring instrument having a hemispherical optical integrator. Whereas the optical semiconductor devices of Example 2 had a total luminous flux (average luminance) of 30 lm, the total luminous flux of the optical semiconductor devices of Comparative Example 2 was as small as 28 lm.

A light reflecting member A' for an optical semiconductor (see Figs. 6 and 7) and an optical semiconductor device using it were manufactured and subjected to evaluation of average luminance in manners described below.

### [Example 3]

### <Manufacture of light reflecting member A'-1 for optical semiconductor>

A light reflecting member A for an optical semiconductor was manufactured in the same manner as in Example 1 and a liner 19 (a PET film MRS50 produced by Mitsubishi Plastics, Inc.) was bonded to the entire surface of the joining layer 2 containing a white pigment. A silicone resin composition was formulated in the following manner, and a silicone resin composition containing a phosphor was produced by adding a YAG phosphor on the market (average particle diameter: 8.9 µm) at 5 mass% based on 100 parts by mass of the thus-formulated silicone resin composition and blending them using a planetary mixer.

### (Silicone resin composition)

A silicone resin composition was formulated by blending the following materials and stirring them at 20°C for 10 min:
dimethylvinylsilyl-terminated polydimethylsiloxane (vinylsilyl group equivalent: 0.071 mol/g): 20 g (vinylsilyl group: 1.4 mmol)
trimethylsilyl-terminated dimethylsiloxane-methylhydrosiloxame copolymer (hydrosilyl group equivalent: 4.1 mmol/g): 0.40 g (hydrosilyl group: 1.6 mmol)
hexamethyldisilazane-treated silica particles: 2 g
xylene solution of platinum-divinyltetramethyldisiloxane complex (platinum concentration: 2 mass%): 0.036 mL (1.9 µmol)
methanol solution of tetramethylammonium hydroxide (10 mass%): 0.063 mL (57 µmol).

The thus-produced silicone resin composition containing a phosphor was charged into the recesses 20 (see Fig. 8) which were formed by the through-holes 3 of the light reflecting member A for an optical semiconductor and the liner 19 by potting using a dispenser (MPP-1 produced by Musashi Engineering, Inc.), and brought into the B-stage by heating it at 80°C for 15 min. Thus, a light reflecting member A'-1 for an optical semiconductor was manufactured in which the through-holes 3 were filled with respective B-stage transparent resin 18.

### <manufacture of optical semiconductor device using light reflecting member A'-1 for optical semiconductor>

Flip-chip optical semiconductor elements (LED chips DA1000 produced by Cree, Inc.) were mounted on the unfoamed surface of a pressure-sensitive adhesive sheet to serve as a substrate (Liva-alpha 31950E produced by Nitto Denko Corporation). After the joining layer 2 containing a white pigment was exposed by peeling the liner 19 off the light reflecting member A'-1 for an optical semiconductor, the optical semiconductor elements were positioned in the respective through-holes 3 and the light reflecting member A'-1 for an optical semiconductor (actually, its joining layer 2 containing a white pigment) was joined to the pressure-sensitive adhesive sheet by applying a pressure 0.2 MPa using a press machine. The resulting structure was heated at 100°C for 1 hour and then at 150°C for 2 hours, whereby the B-stage transparent resin 18 was brought into the C-stage (completely cured) and encapsulation of the optical semiconductor elements was completed. The resulting structure was diced into individual optical semiconductor devices (intended optical semiconductor devices) by a blade dicer.

### [Example 4]

### <Manufacture of light reflecting member A'-2 for optical semiconductor>

A light reflecting member A for an optical semiconductor was manufactured in the same manner as in Example 1 except that a resin formed body 1 was produced by blending, instead of the thermosetting resin composition for formation of the resin formed body 1 of Example 1, by a planetary mixer, a composition containing 100 parts by mass of a thermosetting silicone resin (KER-2500 produced by Shin-Etsu Chemical Co., Ltd.; equal amounts of an A liquid and a B liquid were blended together) and 68 parts by mass of rutile-type titanium oxide (average particle diameter: 0.21 µm) and pouring the resulting composition into a die. Then, a liner 19 (a PET film MRS50 produced by Mitsubishi Plastics, Inc.) was bonded to the entire surface of the joining layer 2 containing a white pigment of the light reflecting member A for an optical semiconductor. Then, in the same manner as in Example 3, a silicone resin composition containing a phosphor was produced, charged into the recesses 20 which were formed by the through-holes 3 of the light reflecting member A for an optical semiconductor and the liner 19 by potting, and brought into the B-stage by heating it. Thus, a light reflecting member A'-2 for an optical semiconductor was manufactured.

### <Manufacture of optical semiconductor device using light reflecting member A'-2 for optical semiconductor>

Intended optical semiconductor devices were manufactured in the same manner as in Example 3 except for the use of the light reflecting member A'-2 for an optical semiconductor.

### [Comparative Example 3]

Optical semiconductor devices were manufactured in the same manner as in Example 3 except that a light reflecting member for an optical semiconductor was manufactured by forming a 100-µm-thick joining layer not containing a white pigment by applying, to the bottom surface of the resin formed body 1, a mere silicone-based pressure-sensitive adhesive (SD4580 produced by Du Pont-Toray Co., Ltd.) not containing rutile-type titanium oxide instead of the composition containing a white pigment. That is, in each optical semiconductor device, the resin formed body 1 is joined to the pressure-sensitive adhesive sheet (substrate) which is mounted with the optical semiconductor element via the joining layer made of the pressure-sensitive adhesive not containing a white pigment rather than the joining layer 2 containing a white pigment.

### <Average luminance evaluation>

Ten individual optical semiconductor devices that were manufactured in each of Examples 3 and 4 and Comparative Example 3 were prepared. They were caused to emit light by driving them at a constant current 350 mA, and luminance values were measured using a total luminous flux measuring instrument having a hemispherical optical integrator. Whereas the optical semiconductor devices of Example 3 had a total luminous flux (average luminance) of 125 lm and the optical semiconductor devices of Example 4 had a total luminous flux of 126 lm, the total luminous flux of the optical semiconductor devices of Comparative Example 3 was as small as 117 lm. It is seen from these results that the light reflecting members A'-1 and A'-2 for an optical semiconductor of Examples 3 and 4 not only enable manufacture of high-performance optical semiconductor devices but also make it possible to form portions for encapsulation in optical semiconductor elements in forming a light reflecting member, that is, to increase productivity.

As is understood from the above description, the light reflecting member for an optical semiconductor according to the invention can be manufactured by a smaller number of steps at a lower cost than conventional ones. Furthermore, capable of being stored at ordinary temperature, the light reflecting member according to the invention can be stored in custody more easily than conventional ones. The substrate for mounting an optical semiconductor according to the invention makes it possible to manufacture high-performance optical semiconductor devices at a low cost. The optical semiconductor device according to the invention is highly resistant to heat, is high in luminance, and can be manufactured at a low cost.

While the invention has been described in detail with reference to specific embodiments thereof, it will be apparent to one skilled in the art that various changes and modifications can be made therein without departing from the spirit and scope thereof.
Incidentally, the present application is based on Japanese Patent Applications No, 2012-129073 filed on June 6, 2012 and No. 2013-060065 filed on March 22, 2013, and the contents are incorporated herein by reference.
All references cited herein are incorporated by reference herein in their entirety.

The invention is suitable for manufacture of a high-quality optical semiconductor device at a low cost.

**Description of Reference Numerals and Signs**

| | |
|---|---|
| 1: | Resin formed body |
| 2: | Joining layer containing a white pigment |
| 3: | Through-hole |
| 3': | Inner circumferential surface of a through-hole |

## Claims

1. A light reflecting member for an optical semiconductor, which is to be joined to an optical semiconductor element mounting surface of a substrate, comprising:
a resin formed body having a through-hole that penetrates through the resin formed body in a top-bottom direction and whose inner circumferential surface is colored in white; and
a joining layer containing a white pigment, which is formed on a bottom surface of the resin formed body,
wherein the light reflecting member is configured so as to be joined to the substrate via the joining layer containing a white pigment in a state that a portion to be mounted with an optical semiconductor element or an optical semiconductor element mounted portion on the substrate is positioned so as to be located in an opening of the through-hole; and
the light reflecting member is configured so that when the optical semiconductor element is mounted in the opening of the through-hole, light emitted from the optical semiconductor element is reflected by the inner circumferential surface of the through-hole.

2. The light reflecting member for an optical semiconductor according to claim 1, wherein the resin formed body is a cured body of a thermosetting resin composition comprising, as a main component, at least one resin selected from the group consisting of an epoxy resin, a silicone resin, a urethane resin, a urea resin, a phenol resin and a melamine resin.

3. The light reflecting member for an optical semiconductor according to claim 1 or 2, wherein the white pigment is at least one compound selected from the group consisting of titanium oxide, zinc oxide, aluminum oxide, magnesium oxide, zirconium oxide, calcium carbonate, barium carbonate and barium sulfate.

4. The light reflecting member for an optical semiconductor according to any one of claims 1 to 3, wherein the resin formed body is formed by transfer molding, compression molding, injection molding or casting molding.

5. The light reflecting member for an optical semiconductor according to any one of claims 1 to 4, wherein the through-hole is filled with a B-stage transparent resin.

6. The light reflecting member for an optical semiconductor according to claim 5, wherein the B-stage transparent resin is a silicone resin.

7. A substrate for mounting an optical semiconductor, comprising:
a substrate; and
the light reflecting member for an optical semiconductor according to any one of claims 1 to 4 which is joined to the substrate,
wherein the portion to be mounted with an optical semiconductor element of the substrate is positioned so as to be located in the opening of the through-hole of the light reflecting member.

8. An optical semiconductor device comprising:
a substrate;
the light reflecting member for an optical semiconductor according to any one of claims 1 to 4 which is joined to and integrated with the substrate;
an optical semiconductor element which is mounted in the opening of the through-hole of the light reflecting member; and
a transparent resin which encapsulates the through-hole.
